# EUROPÄISCHE PATENTANMELDUNG

(11) **EP 1 645 655 A1**
(43) Veröffentlichungstag der Anmeldung: **12.04.2006**
(21) Anmeldenummer: 04023705.9
(22) Anmeldetag: 05.10.2004
(51) Int. Cl.: C23C 14/04

(54) **Bauteil mit Beschichtung und Verfahren zum Herstellen einer Beschichtung**

(71) Anmelder: SIEMENS AKTIENGESELLSCHAFT, 80333 München (DE)
(72) Erfinder: Dobener, Thomas, 46047 Oberhausen (DE); Schmahl, Milan, 45479 Mülheim (DE); Stamm, Werner, Dr., 45481 Mülheim (DE)

(57) **Zusammenfassung**

Ein erfindungsgemäßes Bauteil (1) umfasst einen Grundwerkstoff (2) und eine über dem Grundwerkstoff (2) aufgebrachte Beschichtung (3). Es zeichnet sich dadurch aus, dass in der Beschichtung (3) Dehnungsfugen (5) vorhanden sind.

## Beschreibung

Die vorliegende Erfindung betrifft ein Bauteil mit einer Beschichtung sowie ein Verfahren zum Herstellen einer Beschichtung auf einer Bauteiloberfläche.

Bauteile mit Beschichtungen, wie z. B. mit Wärmedämmbeschichtungen, kommen beispielsweise in Turbinen, etwa in Gasturbinen zur Stromerzeugung, vor. Etwa Turbinenschaufeln oder die Nabe einer Turbine sind in der Regel mit einer thermischen Barrierenschicht (TBC, Thermal Barrier Coating) versehen, um die metallischen Grundkörper gegen den thermischen Einfluss des heißen Gases in der Turbine zu schützen. Bei Verwendung keramischer Beschichtungen als Wärmedämmbeschichtungen kommt darüber hinaus in der Regel noch eine Haftvermittlerschicht zur Anwendung, die auf das metallische Grundmaterial des Bauteils aufgebracht wird, bevor die Beschichtung mit dem keramischen Beschichtungsmaterial erfolgt.

Beim Betrieb von Turbinenbauteilen mit Wärmedämmbeschichtungen kann es zu Abplatzungen und Aufwölbungen der Beschichtung kommen. Eine Ursache hierfür liegt darin, dass die keramische Beschichtung in der Regel einen wesentlich niedrigeren thermischen Ausdehnungskoeffizienten als der metallische Grundkörper des Bauteils aufweist. Wiederholte Zyklen des Aufwärmens und Abkühlens können daher zu Spannungen führen, welche die Aufwölbungen und Abplatzungen verursachen können.

Eine weitere Ursache für Aufwölbungen und Abplatzungen ist die Tatsache, dass manche Keramikbeschichtungen bei hohen Temperaturen für Sauerstoff durchlässig sind, so dass oxidierbare Anteile der Haftvermittlerschicht oxidiert werden können. Wenn die Oxidation mit einer Volumenvergrößerung verbunden ist, kann dies die Abplatzung oder Aufwölbung der Beschichtung verursachen.

Um Abplatzungen und Aufwölbungen einer Beschichtung auf einem Grundkörper zu verhindern, ist in EP 0 935 009 B1 vorgeschlagen, die Oberfläche des Grundkörpers mit einer Skelettstruktur in Form eines Netzes oder eines Gitters zu versehen, und die Beschichtung auf die mit der Skelettstruktur versehene Oberfläche aufzubringen. Dadurch entstehen beim Aufbringen der Beschichtung Hohlräume in der Beschichtung, die für eine Dehnungstoleranz der Beschichtung sorgen.

In DE 42 38 369 A1 ist ein Bauteil aus einem metallischen Grundsubstrat mit einer keramischen Beschichtung beschrieben, bei dem die Oberfläche des Grundsubstrats mit einer Vielzahl von senkrecht vorstehenden Stegen versehen ist. Die Höhe, mit der die Stege über die Oberfläche vorstehen, ist dabei geringer als Dicke der Beschichtung. Während des Aufbringens der Beschichtung bilden sich im Bereich oberhalb der Stege Segmentierungsrisse aus, die sich bis in die Beschichtungsoberfläche fortsetzen. Diese Segmentierungsrisse verbreitern sich bei Betriebstemperatur und schließen sich bei Raumtemperatur, wodurch eine erhöhte Dehnungstoleranz der Beschichtung erzielt wird.

In EP 0 192 162 B1 ist vorgeschlagen, einen metallischen Grundkörper, mit einer metallischen Verankerungsmatrix zu versehen, um die Haftung einer Keramikschicht am Grundkörper zu erhöhen. Die Verankerungsmatrix kann beispielsweise aus wabenförmigen Strukturen, nadelförmigen Strukturen oder stiftförmigen Strukturen aufgebaut sein.

Gegenüber diesem Stand der Technik ist es eine Aufgabe der vorliegenden Erfindung, ein vorteilhaftes Bauteil mit einer Wärmedämmbeschichtung sowie ein vorteilhaftes Verfahren zum Herstellen einer Wärmedämmbeschichtung auf einer Bauteiloberfläche zur Verfügung zu stellen.

Die erste Aufgabe wird durch ein Bauteil nach Anspruch 1, die zweite Aufgabe durch ein Verfahren nach Anspruch 9 gelöst.

Die abhängigen Ansprüche enthalten vorteilhafte Weiterbildungen der Erfindung.

Ein Erfindungsgemäßes Bauteil aus einem Grundwerkstoff, insbesondere aus einem metallischen Grundwerkstoff, mit einer über dem Grundwerkstoff aufgebrachten Beschichtung zeichnet sich dadurch aus, dass in der Beschichtung Dehnungsfugen vorhanden sind.

Mittels der Dehnungsfugen lässt sich die Dehnungstoleranz der Beschichtung erhöhen. Insbesondere bei großflächigen Bauteilen, beispielsweise Nabenbauteilen von Gasturbinen, lassen sich so Abplatzungen und Aufwölbungen einer Wärmedämmbeschichtung vermeiden. Anders als im Stand der Technik werden beim erfindungsgemäßen Bauteil Aufwölbungen und Abplatzungen vermieden, ohne dass sich metallische Elemente von der Bauteiloberfläche aus in die Wärmedämmbeschichtung hinein erstrecken. Metallische Elemente weisen eine gute thermische Leitfähigkeit auf, wodurch sich die Wärmedämmeigenschaften der Wärmedämmschicht gegenüber Wärmedämmschichten ohne metallische Elemente verschlechtern.

In einer Ausgestaltung des erfindungsgemäßen Bauteils sind die Dehnungsfugen netzartig über die Oberfläche der Beschichtung verteilt. Insbesondere können Sie die Oberfläche der Beschichtung in viereckige, beispielsweise quadratische oder rechteckige, oder in sechseckige Oberflächenbereiche unterteilen. Auch andere Geometrien sind möglich. Durch gezielte Auswahl der Form des Netzes bzw. der Geometrie der durch die Dehnungsfugen erzeugten Oberflächenbereiche lassen sich die Dehnungseigenschaften der Beschichtung gezielt an die Geometrie des Bauteils anpassen. Um die Dehnungstoleranz der Beschichtung weiter zu erhöhen, kann sie eine Porosität aufweisen.

Insbesondere kann die Beschichtung als keramische Beschichtung zur Wärmedämmung ausgestaltet sein. Wenn zudem der Grundwerkstoff ein metallischer Grundwerkstoff ist, ist es vorteilhaft, wenn zwischen dem Grundwerkstoff und der keramischen Wärmedämmbeschichtung eine Haftvermittlerschicht vorhanden ist. Mitteils der Haftvermittlerschicht lässt sich ein sicheres Haften der keramischen Wärmedämmbeschichtung auf dem metallischen Grundwerkstoff erzielen.

Das erfindungsgemäße Bauteil kann insbesondere als Turbinenbauteil, beispielsweise als Nabenbauteil einer Turbine, ausgestaltet sein.

Im erfindungsgemäßen Verfahren zum Herstellen einer Beschichtung auf einer Bauteiloberfläche wird vor dem Aufbringen der Beschichtung eine Struktur aus draht- oder seilförmigen Elementen mit Abstand über der Beuteiloberfläche angeordnet. Nach dem Aufbringen der Beschichtung wird die Struktur dann wieder entfernt. Beim Beschichten wird die Beschichtung in den durch die Struktur abgedeckten Bereichen weniger stark auftragen als in den nicht abgedeckten Bereichen. Im Ergebnis entstehen die Dehnungsfugen der Beschichtung.

Das Aufbringen der beispielhaft erwähnten Wärmedämmbeschichtung kann insbesondere mittels eines thermischen Spritzverfahrens, beispielsweise atmosphärischen Plasmaspritzens (APS) oder Hochgeschwindigkeitsflammspritzens (HVOF, high velocity oxygen fuel) oder eines Abscheideprozesses aus der Gasphase, beispielsweise eines so genannten EB-PVD-Verfahrens (electron beam physical vapor deposition erfolgen). In einem EB-PVD-Verfahren wird das Beschichtungsmaterial mittels eines Elektronenstrahls von einem Vorrat abgedampft, wobei die Bedingungen in der Umgebung des Bauteils beim Beschichten so eingestellt sind, dass sich das abgedampfte Material aus der Gasphase auf die zu beschichtenden Oberfläche anlagert.

Weitere Merkmale, Eigenschaften und Vorteile der vorliegenden Erfindung ergeben sich aus der nachfolgenden Beschreibung eines Ausführungsbeispiels unter Bezugnahme auf die beiliegenden Figuren.

Figur 1 zeigt ein erstes Ausführungsbeispiel für ein erfindungsgemäßes Bauteil mit Wärmedämmbeschichtung in Draufsicht.

Figur 2 zeigt einen vergrößerten Ausschnitt des Bauteils aus Figur 1 in einem Querschnitt entlang der Linie A A.

Figur 3 zeigt ein zweites Ausführungsbeispiel für das erfindungsgemäße Bauteil mit Wärmedämmbeschichtung in einer Draufsicht.

Figur 4 zeigt ein drittes Ausführungsbeispiel für ein erfindungsgemäßes Bauteil mit Wärmedämmschichtung in einer Draufsicht.

Figur 5 zeigt einen Schritt des erfindungsgemäßen Herstellungsverfahrens für ein erfindungsgemäßes Bauteil mit Wärmedämmbeschichtung.

Figur 6 zeigt einen Schritt des erfindungsgemäßen Herstellungsverfahrens zum Aufbringen einer Wärmedämmbeschichtung auf ein Nabenbauteil einer Turbine.

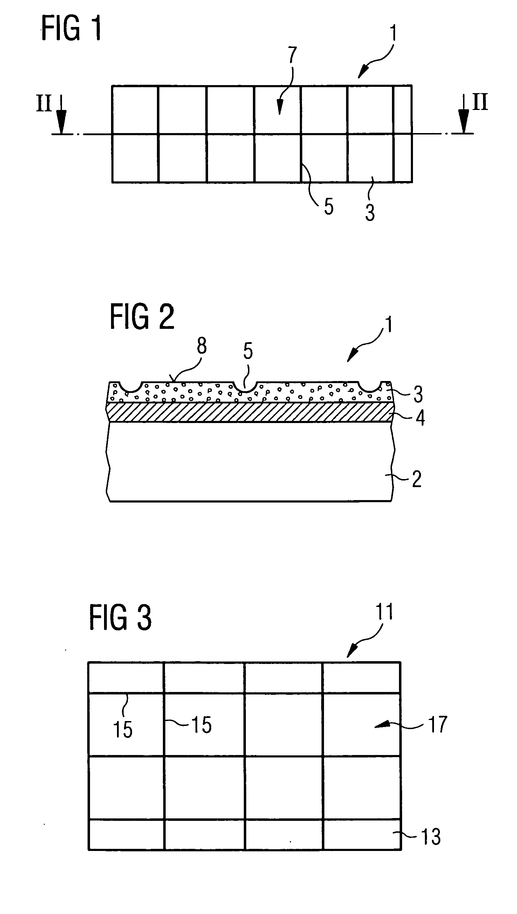

Als ein erstes Ausführungsbeispiel für ein erfindungsgemäßes Bauteil mit Beschichtung ist in den Figuren 1 und 2 schematisch ein großflächiges Turbinenbauteil 1 mit einer Wärmedämmbeschichtung 3 dargestellt.
Während Figur 1 das Turbinenbauteil 1 in Draufsicht zeigt, zeigt Figur 2 das Turbinenbauteil 1 in ein Schnitt entlang der Linie II - II, wobei die Schnittdarstellung im Vergleich zu Figur 1 vergrößert dargestellt ist.
Die Erfindung wird am Beispiel einer Wärmedämmbeschichtung für eine Beschichtung näher erläutert.

Das Turbinenbauteil 1 weist einen metallischen Grundkörper 2 auf, auf dem eine Haftvermittlerschicht 4 aufgebracht ist. Die Haftvermittlerschicht 4 dient dabei dazu, die Haftung der Wärmedämmbeschichtung 3, die im Ausführungsbeispiel als keramische Wärmedämmbeschichtung ausgebildet ist, am metallischen Grundkörper 2 zu erhöhen.

Die Wärmedämmbeschichtung 3 ist auf das Turbinenbauteil 1 flächig aufgebracht und weist in regelmäßigen Abständen parallel zu einander verlaufende Dehnfugen 5 auf. Im Bereich der Dehnfugen ist die Materialstärke der Wärmedämmschicht etwa auf die Hälfte reduziert. Je nach zu erwartender thermischer Belastung des Bauteils kann sie auch eine geringere oder stärkere Reduzierung aufweisen.

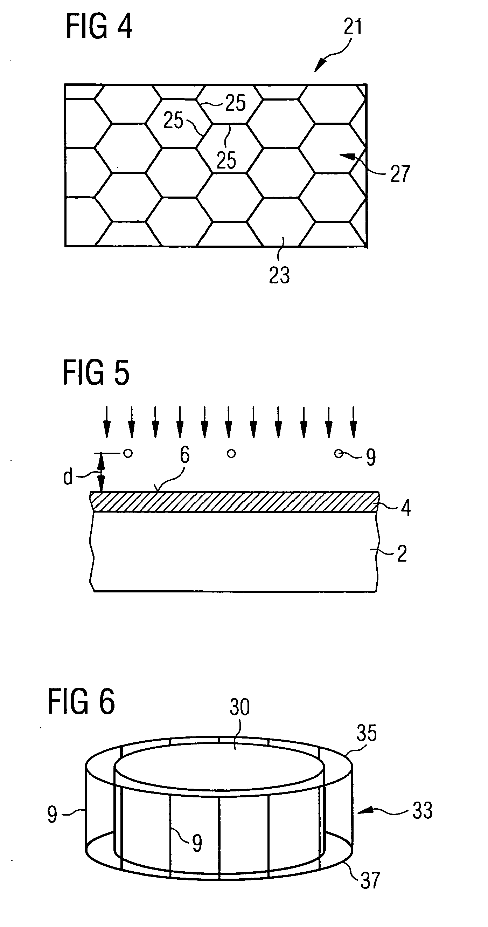

Die Oberfläche der Wärmedämmbeschichtung 3 wird durch die Dehnfugen 5 in eine Anzahl Oberflächenbereiche 7 unterteilt. Diese Oberflächenbereiche 7 sind im vorliegenden Ausführungsbeispiel rechteckig, sie können jedoch auch quadratisch oder wabenförmig, insbesondere sechseckförmig, sein, wie dies in den Figuren 3 und 4 dargestellt ist.

Wenn sich beim Betrieb der Turbine das metallische Grundmaterial 2 des Turbinenbauteils 1, 11, 21 stärker ausdehnt als das Beschichtungsmaterial der Wärmedämmbeschichtung 3, 13, 23 so ermöglichen die Dehnfugen 5, 15, 25 eine Ausdehnung der Wärmedämmschicht 3, 13, 23 ohne dass übermäßige Spannungen auftreten. Je nach Qualität und Quantität der auftretenden Spannungen kann die Geometrie der Dehnfugen geeignet gewählt werden. Treten beispielsweise Spannungen vorzugsweise in einer Richtung auf, so ist es, wie in Figur 1 dargestellt, möglich das Bauteil lediglich mit parallel zu einander verlaufenden Dehnfugen zu versehen.
Anders als in Figur 1 dargestellt, brauchen die Dehnfugen 15, 25 aber nicht in regelmäßigen Abständen voneinander angeordnet zu sein. Vielmehr können die Abstände auch unregelmäßig sein oder einen periodischen Verlauf aufweisen. Treten hingegen die Spannungen nicht nur bevorzugt in einer Richtung auf, so kann es vorteilhaft sein, wenn sich die Dehnfugen 15, 25 in verschiedenen Richtungen über die Oberfläche 8 der Wärmedämmbeschichtung 3, 13, 23 erstrecken. In diesem Fall bilden die Dehnfugen 5 dann eine Netzstruktur auf der Oberfläche 8 der Wärmedämmbeschichtung 3, wie dies in den Figuren 3 und 4 zu erkennen ist.

Die Dehnungstoleranz der Wärmedämmbeschichtung 3 kann weiter verbessert werden, wenn diese eine Porosität aufweist.

Ein Verfahren zum Aufbringen einer Wärmedämmbeschichtung mit Dehnfugen wird nachfolgend mit Bezug auf die Figuren 5 und 6 erläutert. In Figur 5 ist ein wesentlicher Verfahrensschritt beim Aufbringen der Wärmedämmbeschichtung 3 dargestellt, Figur 6 zeigt ein Nabenbauteil einer Turbine vor dem Aufbringen der Wärmedämmbeschichtung.

Im erfindungsgemäßen Verfahren wird dort, wo sich die Dehnfugen 5 später befinden sollen, eine draht- oder seilförmige Struktur über der Oberfläche des Grundkörpers oder, wenn vorhanden, der Oberfläche 6 der Haftvermittlerschicht 4 angeordnet. Im vorliegenden Ausführungsbeispiel werden gespannte Drähte 9 mittels eines Rahmens (in Fig. 5 nicht dargestellt) mit einem Abstand d über der Oberfläche 6 der Haftvermittlerschicht 4 fixiert. Der Abstand d ist dabei größer als die spätere Dicke der Wärmedämmbeschichtung 3.

Im vorliegenden Ausführungsbeispiel wird nach dem Anbringen des Rahmens mit den gespannten Drähten 9 die keramische Wärmedämmbeschichtung 3 mittels eines EB-PVD-Verfahrens, d.h. durch Abscheiden aus der Gasphase, auf die Haftvermittlerschicht 4 aufgebracht. Dabei lagert sich in denjenigen Bereichen der Oberfläche 6 der Haftvermittlerschicht 4, die sich im Schatten der Drähte 9 befinden, weniger keramisches Material ab als in den Bereichen zwischen den Drähten 9. Auf diese Weise ist die Materialstärke im Schatten der Drähte 9 nach dem Beenden des Abscheidprozesses geringer als zwischen den Drähten 9. Die Bereiche verringerter Materialstärke bilden dann die Dehnfugen 5 in der fertigen Wärmedämmbeschichtung 3. Breite und Tiefe der Dehnfugen 5 können variiert werden, indem beispielsweise die Richtung, aus der die Abscheidung des keramischen Materials erfolgt, während des Abscheideprozesses variiert wird. Auch durch den Abstand der Drähte 9 zum zu beschichtenden Grundkörper 2 können die Dehnfugen verändert werden.

Im erfindungsgemäßen Verfahren kann der spätere Verlauf der Dehnfugen 5 durch den Verlauf der Drähte 9 bestimmt werden. Wenn beispielsweise die in Figur 4 dargestellte wabenförmige Struktur erzeugt werden soll, so werden mittels des Rahmens nicht einzelne Drähte, sondern ein Drahtnetz mit der entsprechenden Struktur über der zu beschichtende Oberfläche angebracht.

Figur 6 zeigt ein Beispiel für die Durchführung des erfindungsgemäßen Verfahrens an einem Nabenbauteil 30 einer Gasturbine. Um das Nabenbauteil 30 herum wird ein Rahmen 33 angebracht, der zwei Rahmenteile 35 und 37 umfasst, zwischen denen Drähte 9 gespannt sind. Beim Aufbringen der keramischen Wärmedämmbeschichtung sorgen diese Drähte 9 dann für das Entstehen der Dehnfugen. Das erfindungsgemäße Verfahren ermöglicht es insbesondere, großflächige Bauteile wie etwa Nabenbauteile von Turbinen mit dehnungstoleranten Wärmedämmbeschichtungen zu versehen. Außerdem ist es mit dem erfindungsgemäßen Verfahren möglich, die dehnungstoleranten Strukturen unter Verwendung der bisherigen Abscheideverfahren für die Wärmedämmbeschichtung herzustellen.

Der Abstand d, mit dem die Drähte 9 über der zu beschichtenden Oberfläche 6 angebracht werden, beträgt im Ausführungsbeispiel mindestens ca. 0,2 mm. Er kann jedoch je nach gewünschter Tiefe und Breite der Dehnfugen variiert, insbesondere vergrößert werden.

Als Haftvermittlerschicht 4 kann beim erfindungsgemäßen Bauteil insbesondere eine MCrAlY-Schicht, also eine Schicht aus einer metallischen Legierung, die Chrom (Cr) und Aluminium (A1) umfasst und in der Y für Yttrium oder ein Element der seltenen Erden und M für Eisen (Fe), Kobalt (Co) oder Nickel (Ni) stehen zur Anwendung kommen. Als keramische Wärmedämmbeschichtung eignen sich insbesondere auf Zirkon (Zr) basierende Beschichtungen, beispielsweise eine Zirkonoxidbeschichtung.

## Patentansprüche

1. Bauteil (1) aus einem Grundwerkstoff (2) mit einer über dem Grundwerkstoff (2) aufgebrachten Beschichtung (3), insbesondere einer Wärmedämmbeschichtung,
**dadurch gekennzeichnet,**
**dass** in der Beschichtung (3) Dehnungsfugen (5) vorhanden sind.

2. Bauteil (1) nach Anspruch 1,
**dadurch gekennzeichnet,**
**dass** die Dehnungsfugen (5) netzartig über die Oberfläche (8) der Beschichtung (3) verteilt sind.

3. Bauteil (1) nach Anspruch 2,
**dadurch gekennzeichnet,**
**dass** die netzartig verteilten Dehnungsfugen (5) die Oberfläche (8) der Beschichtung in viereckige oder sechseckige Oberflächenbereiche (7) unterteilen.

4. Bauteil (1) nach einem der vorangehenden Ansprüche,
**dadurch gekennzeichnet,**
**dass** die Beschichtung (3) eine Porosität aufweist.

5. Bauteil (1)nach einem der vorangehenden Ansprüche,
**dadurch gekennzeichnet,**
**dass** die Beschichtung (3) eine keramische Beschichtung ist.

6. Bauteil (1) nach Anspruch 5,
**dadurch gekennzeichnet,**
**dass** der Grundwerkstoff (2) ein metallischer Grundwerkstoff ist und zwischen dem Grundwerkstoff (2) und der keramischen Wärmedämmbeschichtung (3) eine Haftvermittlerschicht (4) vorhanden ist.

7. Bauteil (1) nach einem der vorangehenden Ansprüche, **gekennzeichnet durch** seine Ausgestaltung als Turbinenbauteil (11).

8. Bauteil (1) nach Anspruch 7, **gekennzeichnet durch** seine Ausgestaltung als Nabenbauteil einer Turbine.

9. Verfahren zum Herstellen einer Beschichtung, insbesondere einer Wärmedämmbeschichtung (3) auf einer Bauteiloberfläche,
**dadurch gekennzeichnet,**
**dass** vor dem Aufbringen der Beschichtung (3, 13, 23) eine Struktur aus draht- oder seilförmigen Elementen (9) mit Abstand (d) über der Bauteiloberfläche (6) angeordnet und nach dem Aufbringen der Beschichtung (3, 13, 23) wieder entfernt wird.

10. Verfahren nach Anspruch 9,
**dadurch gekennzeichnet,**
**dass** das Aufbringen der Beschichtung (3, 13, 23) mittels eines thermischen Spritzverfahrens oder eines Abscheideprozesses aus der Gasphase erfolgt.

11. Verfahren nach Anspruch 9,
**dadurch gekennzeichnet,**
**dass** die Struktur aus den draht- oder seilförmigen Elementen (9) eine netzartige Struktur aufweist.

12. Verfahren nach Anspruch 11,
**dadurch gekennzeichnet,**
**dass** die netzartig verteilten Dehnungsfugen (5, 15, 25) die Oberfläche (8) der Beschichtung (3, 13, 23) in viereckige oder sechseckige Oberflächenbereiche (7, 17, 27) unterteilt.

13. Verfahren nach Anspruch 9,
**dadurch gekennzeichnet,**
**dass** die Struktur aus den draht- oder seilförmigen Elementen (9) so verteilt sind,
**dass** sich eine viereckige Struktur mit unterschiedlichen Abständen der parallel verlaufenden Dehnungsfugen (5, 15, 25) ergibt.
